(19) **Europäisches Patentamt / European Patent Office / Office européen des brevets**

(11) **EP 1 930 364 A1**

(12) **EUROPEAN PATENT APPLICATION**

(43) Date of publication:
**11.06.2008 Bulletin 2008/24**

(51) Int Cl.:
*C08J 9/00* (2006.01)    *H05K 9/00* (2006.01)

(21) Application number: **06025002.4**

(22) Date of filing: **04.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicants:
- **Université Catholique De Louvain**
  **1348 Louvain-La-Neuve (BE)**
- **Université de Liège**
  **4031 Angleur (BE)**

(72) Inventors:
- **Jerome, Robert**
  **4845 Jalhay (BE)**
- **Pagnoulle, Christophe**
  **4800 Verviers (BE)**

- **Detrembleur, Christophe**
  **4000 Liege (BE)**
- **Thomassin, Jean-Michel**
  **4670 Blegny (BE)**
- **Huynen, Isabelle**
  **1348 Louvain-la-neuve (BE)**
- **Bailly, Christian**
  **2000 Antwerpen (BE)**
- **Bednarz, Lukasz**
  **1435 Mont-Saint-Guibert (BE)**
- **Daussin, Raphael**
  **6900 Marloie (BE)**
- **Saib, Aimad**
  **5030 Gembloux (BE)**

(74) Representative: **Bird, William Edward et al**
**Bird Goën & Co.**
**Klein Dalenstraat 42A**
**3020 Winksele (BE)**

(54) **Polymer composite material structures comprising carbon based conductive loads**

(57)    The present invention provides a polymer composite material structure comprising at least one layer of a foamed polymer composite material comprising a foamed polymer matrix and 0.1 to 6 wt% carbon based conductive loads, such as e.g. carbon nanotubes, dispersed in the foamed polymer matrix. The polymer composite material structure according to embodiments of the present invention shows good shielding and absorbing properties notwithstanding the low amount of carbon based conductive loads. The present invention furthermore provides a method for forming a polymer composite material structure comprising carbon based conductive loads.

FIG. 3

## Description

### Technical field of the invention

The present invention relates to polymer composite material structures comprising carbon based conductive loads such as e.g. carbon nanotubes (CNTs) and/or carbon black, and to a method for forming such polymer composite material structures. The polymer composite material structures according to embodiments of the present invention have good electromagnetic interference shielding properties and good electromagnetic absorbing properties and can be used as electromagnetic interference shields in, for example, radio frequency systems.

### Background of the invention

Conducting polymer composites, based on the association of a polymer core with conductive loads, are highly attractive because they associate two antagonistic concepts, i.e. "polymer", which implies an insulator, and "electrical conduction". This characteristic can find applications, for example, in the design of coatings able to limit electromagnetic pollution. Electromagnetic shielding is one of the strongest growth areas for development of materials. Due to the emergence of a large number of high rate data transmission systems and satellite, hertzian or mobile communications, the problem of electromagnetic interferences is becoming a growing environmental concern.

Due to the high level of conductivity required for efficient electromagnetic shielding, only two families of conductive loads, which reflect or absorb the electromagnetic radiation, have traditionally been found suitable for being dispersed inside a polymer, e.g. stainless steel fibres (obtainable from Bekaert Fibre Technology ®) and nickeled carbon fibres (obtainable from Inco SSP ®).

For obtaining a sufficient conductivity, the loading should be relatively high, i.e. about 11-15%, which gives rise to negative effects on the density, the mechanical properties, surface quality and cost of the final product. Moreover, due to the macroscopic lengths of the fibres, moulding and processing with conventional extrusion methods is difficult because it is very difficult to avoid extensive breakage of the fibres during processing because shielding properties are strongly linked to the aspect ratio (=length/diameter) of the fibres, which can lead to a degradation of properties of the fibres. This is one of the most important limitations for electromagnetic broadband applications, such as microwave shields and absorbers, for which the best performances results from an optimisation of the geometry and the concentration in conductive inclusions, e.g. profile in gradient of concentration [Neo and al., IEEE Transactions on Electromagnetic Compatibility, vol. 46, no.1, Feb. 2004, p.102-106].

There is a growing interest in carbon nanotubes (CNTs) formed of one or more concentric graphite cylinders (respectively single or multi-wall CNTs) because of the remarkable properties of these materials, i.e. a combination of lightness, hardness, elasticity, chemical resistance, thermal conductivity and, according to their molecular symmetry, electric conductivity which is higher than the electric conductivity of copper. All these characteristics, as well as a nanoscopic and high anisotropy (ratio length/diameter higher than 1000) makes CNTs a perfect candidate for the next generation of conducting composites, in particular, by ensuring their "percolation" (or continuous network formation) at lower load factors than those observed with other conductive fibres but without the disadvantages of these other conductive fibres. Moreover, CNTs are sufficiently short to be dispersed inside a polymer by conventional extrusion/injection techniques without risking them to break, after which they can be moulded into desired shapes.

Conventionally, when electromagnetic interference (EMI) shielding is cited as one of the promising outlets of composite materials based on carbon nanotubes and on polymer foams as a matrix, shielding properties have been observed at the detriment of electromagnetic absorbent behaviour [Yang and al. Adv. Mat., 2005 (17), p.1999-2003; Yang et al. Nano Letters, 2005, 5(11), p.2131-2134]. In Yang et al., the carbon nanotube-polymer foam composites have a reflectivity of 0.81, a transmissivity of 0.01 and an absorptivity of 0.18, which indicates that these composite materials are more reflective and less absorptive of electromagnetic radiation and thus that the primary EMI shielding mechanism of such composites is reflection rather than absorption in the X-band frequency region.

Hence, the composite materials presented in the state of art prove to be good shields, because they reflect almost all incident power at the input interface (air-material) so that no signal goes through the material, but are poor absorbents since the power is reflected at the interface instead of being completely absorbed in the composite material.

### Summary of the invention

It is an object of the present invention to provide polymer composite material structures with good properties and a good method for forming such polymer composite material structures.

The above objective is accomplished by a method and device according to the present invention.

It is an advantage of the polymer composite material structures according to embodiments of the present invention that they show good electromagnetic interference (EMI) shielding properties and good electromagnetic absorbing properties notwithstanding the fact that they only have a low content of carbon based conductive materials.

The polymer composite material structures according to embodiments of the present invention can be used as electromagnetic interference shield in, for example, radio frequency systems.

In a first aspect of the present invention, a polymer composite material structure is provided comprising at least one layer of a foamed polymer composite material comprising:

- a foamed polymer matrix, and
- an amount of between 0.1 and 6 wt%, preferably between 0.5 and 4 wt%, and more preferably between 0.5 and 2 wt% or between 0.5 and 1 wt%, carbon based conductive loads dispersed in the foamed polymer matrix,

wherein the polymer composite material structure has a reflectivity between -5 and -20 dB, preferably between -10 and -20 dB and most preferably between -15 and -20 dB.

An advantage of the polymer composite material structure according to embodiments of the present invention is that a lower amount of carbon based conductive loads such as e.g. carbon nanotubes (CNTs) and/or carbon black (CB) particles, are required to obtain good reflecting and absorbing properties. Reflectivity is a negative measure for the absorbing properties of the composite material. The lower the reflectivity is, the better the absorbing properties of the polymer composite material structure can be. Good reflective and/or absorbing properties allow the polymer composite material structure according to embodiments of the present invention to be used as an electromagnetic interference shield in, for example, radio frequency systems. Furthermore, because of the low content of carbon based conductive loads required to obtain a polymer composite material structure with good reflecting and absorbing properties, the manufacturing of such polymer composite material structures has a lower cost and is easier to perform.

According to preferred embodiments, the foamed polymer matrix may be an annealed foamed polymer matrix.

According to embodiments of the invention, the polymer composite material structure may comprise more than one layer of foamed polymer composite material as described above, to form a multilayered composite material structure. Preferably, each of the layers of foamed polymer composite material may comprise a different content of carbon based conductive loads such that a concentration gradient of carbon based conductive loads or charges exists in the polymer composite material structure. An advantage of polymer composite material structures comprising such multilayer structures with a conductive load concentration gradient is that the good properties of the polymer composite material structures according to embodiments of the present invention as described above can be improved.

According to other embodiments of the invention, the polymer composite material structure may furthermore comprise at least one layer of a non-foamed or solid polymer composite material. In other words, according to these embodiments, the polymer composite material structure may comprise at least one layer of foamed polymer composite material and at least one layer of non-foamed or solid polymer composite material. The number of layers of foamed polymer composite materials does not need to be the same as the number of layers of non-foamed composite material.

The polymer composite material structure may have a shielding effectiveness of between 5 and 90 dB, preferably between 40 and 90 dB, more preferably between 60 and 90 dB and most preferably between 70 and 90 dB.

As already mentioned, the polymer composite material structure according to embodiments of the invention is well-suited for use as electromagnetic interference shields in, for example, radio frequency systems, notwithstanding the fact that it comprises only a low amount, i.e. between 0.1 wt% and 6 wt% of carbon based conductive loads.

According to preferred embodiments of the invention, the carbon based conductive loads may comprise carbon nanotubes (CNTs). CNTs have an interesting combination of properties, i.e. a combination of lightness, hardness, elasticity, chemical resistance, thermal conductivity and, according to their molecular symmetry, electric conductivity, which is higher than the electric conductivity of copper. Because of that they are a very good candidate to be used as carbon based conductive loads in the polymer composite material structure according to embodiments of the present invention.

According to other embodiments of the present invention, the carbon based conductive loads may comprise carbon nanotubes (CNTs) and carbon black (CB) particles. An advantage of using a combination of CNTs and CB particles is that it allows obtaining a composite with improved properties compared to a composite only comprising CNTs or only comprising CB.

The CNTs may be single-wall CNTs, double-wall CNTs, multi-wall CNTs or combinations thereof. Most preferably, the CNTs may be multi-wall CNTs.

The CNTs may be functionalised. The CNTs may, for example, be modified by chemical modification, physical adsorption of molecules at the surface, metallization, or a combination thereof. Commercially available functionalised CNTs may also be used. For example, amino-, hydroxyl-, carboxylic acid-, thiol- functionalised carbon nanotubes may be used. Some products are made available by Nanocyl SA under the commercial names Nanocyl ®-3152 for multi-wall carbon nanotubes surface modified by amino groups, Nanocyl ®-3153 for multi-wall carbon nanotubes surface modified by hydroxyl groups, Nanocyl ®-3151 and Nanocyl ®-3101 for multi-wall carbon nanotubes surface modified by carboxylic acid groups, and Nanocyl ®-3154 for multi-wall carbon nanotubes surface modified by thiol groups. These examples are not intended to be restrictive and other surface functionalised carbon nanotubes are made available by several carbon nanotubes companies and may be used with embodiments of the present invention.

According to embodiments of the invention, the polymer matrix may comprise a polar polymer. The polar polymer may be one of the group of a polyester, a polyacrylate, a polymethacrylate, a polyurethane, a polycarbonate or a copolymer comprising olefins with acrylic or methacrylic monomers. Most preferably, the polar polymer may be a polyester.

The polymer composite material structure may be incorporated in a radio frequency system as an electromagnetic interference shield.

The present invention also provides the use of the polymer composite material structure according to embodiments of the present invention as an electromagnetic interference shield in radio frequency systems.

In a further aspect, the invention provides a method for forming a polymer composite material structure, in particular a composite material structure in accordance with embodiments of the present invention, the method comprising providing at least one layer of a foamed polymer composite material by:

- providing a polymer matrix,
- dispersing an amount of 0.1 to 6 wt%, preferably between 0.5 and 4 wt%, more preferably between 0.5 and 2 wt% or between 0.5 and 1 wt% carbon based conductive loads hereby forming a polymer composite material, and
- foaming the polymer composite material,
- and providing an annealed polymer composite material by annealing the polymer composite material before foaming or by annealing the foamed polymer composite material.

Annealing of the polymer composite material before foaming or annealing the foamed polymer composite material results in a polymer composite material structure with a reflectivity of between -5 and -20 dB, preferably between -10 and -20 dB and most preferably between -15 and -20 dB because it improves percolation or continuous network formation of the carbon based conductive loads inside the polymer matrix. Reflectivity is a negative measure for the absorbing properties of the polymer composite material structure. The lower the reflectivity is, the better the absorbing properties of the composite material structure can be. Because of the good reflectivity and absorptivity, the polymer composite material structures may have a shielding effectiveness 5 and 90 dB, preferably between 40 and 90 dB, more preferably between 60 and 90 dB and most preferably between 70 and 90 dB.

A further advantage of method according to embodiments of the invention is that it leads to polymer composite material structure only requiring a low amount of carbon based conductive loads such as e.g. carbon nanotubes (CNTs) and/or carbon black (CB) particles, to obtain good reflecting and absorbing properties.

Annealing may be performed at a temperature equal to or higher than the glass transition temperature (Tg) of the polymer matrix in case of amorphous polymers or at a temperature equal to or higher than the melting point (Tm) of the polymer matrix in case of semi-crystalline polymers. Foaming the polymer composite material may be performed by adding a chemical or physical foaming agent to the polymer composite material.

According to embodiments of the invention, the method may furthermore comprise providing more than one layer of a foamed polymer composite material. In this way, multilayered composite material structures may be formed. Preferably, each of the layers of foamed polymer composite material may comprise a different content of carbon based conductive loads such that a concentration gradient of carbon based conductive loads or charges exists in the polymer composite material structure. An advantage of polymer composite material structures comprising such multilayer structures with a conductive load concentration gradient is that the good properties of the polymer composite material structures according to embodiments of the present invention as described above can be improved.

According to other embodiments of the invention, the method may furthermore comprise providing at least one layer of a non-foamed or solid polymer composite material. According to these embodiments a polymer composite material structure may be formed comprising at least layer of a foamed polymer composite material and at least one layer of a non-foamed or solid polymer composite material.

Providing at least one layer of a non-foamed polymer composite material may comprise:

- providing a polymer matrix,
- dispersing an amount of 0.1 to 6 wt%, preferably between 0.5 and 4 wt%, and more preferably between 0.5 and 2 wt% or between 0.5 and 1 wt% carbon based conductive loads, hereby forming a polymer composite material, and
- optionally annealing the polymer composite material.

According to embodiments of the invention, the method may furthermore comprise pelletizing the polymer composite material before annealing it.

According to preferred embodiments of the invention, the carbon based conductive loads may comprise carbon nanotubes (CNTs). CNTs have an interesting combination of properties, i.e. a combination of lightness, hardness, elasticity, chemical resistance, thermal conductivity and, according to their molecular symmetry, electric conductivity, which is higher than the electric conductivity of copper. Because of that they are a very good candidate to be used as carbon based conductive loads in the polymer composite material structure according to embodiments of the present invention.

According to other embodiments of the present invention, the carbon based conductive loads may comprise carbon nanotubes and carbon black particles. An advantage of using a combination of CNTs and CB particles is that it allows obtaining a composite with improved properties compared to a composite only comprising CNTs or only comprising CB.

The CNTs may be single-wall CNTs, double-wall CNTs, multi-wall CNTs or combinations thereof. Most preferably, the CNTs may be multi-wall CNTs.

The CNTs may be functionalised. For example, the CNTs may be modified by chemical modification, physical adsorption of molecules at the surface, metallization, or a combination thereof. Commercially available functionalised CNTs may also be used. For example, amino-, hydroxyl-, carboxylic acid-, thiol- functionalised carbon nanotubes may be used. Some products are made available by Nanocyl SA under the commercial names Nanocyl ®-3152 for multi-wall carbon nanotubes surface modified by amino groups, Nanocyl ®-3153 for multi-wall carbon nanotubes surface modified by hydroxyl groups, Nanocyl ®-3151 and Nanocyl ®-3101 for multi-wall carbon nanotubes surface modified by carboxylic acid groups, and Nanocyl ®-3154 for multi-wall carbon nanotubes surface modified by thiol groups. These examples are not restrictive and other surface functionalised carbon nanotubes are made available by several carbon nanotubes companies and may be used with embodiments of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 shows the conductivity of a polycaprolactone polymer and of a CNT/polycaprolactone composite material structure without annealing, after 1 hour of annealing and after 15 hours of annealing.

Fig. 2 shows the shielding effectiveness (SE) and the reflectivity of a solid (non-foamed) CNT/polyethylene composite having a thickness of 2 cm and comprising 0.5 weight percent CNTs according to the prior art.

Fig.3 shows a comparison of the dielectric constant, reflectivity, conductivity and shielding efficiency of solid (non-foamed) and CNT/polycaprolactone composite materials.

Fig.4 illustrates a carbon nanotube/polymer composite material (a) comprising a monolayer of material and (b) comprising a tri-layer of material according to embodiments of the present invention.

Fig. 5A shows the shielding effectiveness and Fig. 5B shows the reflectivity for monolayers of foamed CNT/ polycaprolactone composite materials comprising different amounts of CNTs and for tri-layers of foamed CNT/polycaprolactone composite materials comprising a CNT concentration gradient according to embodiments of the present invention.

Fig. 6A shows the shielding effectiveness, Fig. 6B shows the reflectivity and Fig. 6C shows the conductivity for monolayers of foamed CNT/polycaprolactone composite materials comprising different amounts of CNTs and for tri-layer CNT/polycaprolactone composite material structures comprising a CNT concentration gradient according to embodiments of the present invention.

Fig. 7 illustrates the electrical conductivity as a function of frequency for a foamed 2 weight percent CNT/ Lotader® polymer composite material without annealing and after annealing for 2 hours.

Fig. 8A shows the shielding effectiveness and Fig. 8B shows the reflectivity for monolayers of polycaprolactone (PCL) based composite materials and for monolayers Lotader® polymer composite materials comprising different amounts of CNTs compared to tri-layer composite material structures comprising foamed PCL+1wt%CNT/solid Lotader® +2wt%CNT/foamed PCL+4wt%CNT according to embodiments of the present invention.

Fig.9 illustrates the dielectric constant for polycaprolactone and Lotader® polymer, both without carbon based conductive loads.

Fig. 10 shows the electrical conductivity as a function of frequency for a polycaprolactone polymer comprising different amounts of carbon black (CB) compared to a polycaprolactone polymer comprising 0.7 wt% CNTs according to embodiments of the present invention.

Fig. 11 shows the electrical conductivity as a function of frequency for a Lotader® polymer filled with 2 wt% CNTs (without annealing) and for a Lotader® polymer comprising 2 wt% CNTs and 2 wt% CB (after annealing for 2 hours).

In the different figures, the same reference signs refer to the same or analogous elements.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In one aspect, the present invention provides a polymer composite material structure based on carbon based conductive loads or charges dispersed inside a foamed polymer matrix and a method for forming composite material structures comprising a polymer matrix and carbon based conductive loads or charges.

The term 'carbon based conductive loads' is used to indicate suitable carbon based conductive materials, especially nanoscopic carbon based charges with high aspect ratio of at least 10, preferably at least 100, more preferably at least 1000, that can be incorporated in a polymer matrix such as e.g. carbon nanotubes (CNTs), carbon black (CB) particles, carbon fibres, or a combination thereof, and which may optionally be metallized.

The present invention provides polymer composite material structures comprising at least one layer of a foamed polymer composite material. The at least one foamed polymer composite material comprises a foamed polymer matrix, which may preferably be an annealed foamed polymer matrix, an amount of between 0.1 and 6 weight percent (wt%), preferably between 0.5 and 4 wt%, and more preferably between 0.5 and 2 wt% or between 0.5 and 1 wt%, carbon based conductive loads or charges, such as e.g. CNTs or CB particles or a combination thereof, dispersed in the foamed polymer matrix. The polymer composite material structure according to the present invention has a reflectivity of between -5 and -20 dB. According to embodiments of the invention the polymer composite material structure may comprise at least one further layer of foamed polymer composite material and/or at least one layer of a non-foamed polymer composite material.

The present invention will be illustrated and clarified by means of experiments and examples (see further) of polymer composite material structures comprising CNTs and a combination of CNTs and CB, but this is not intended to limit the invention in any way. Other suitable carbon based conductive loads or charges as described above may also be used with the present invention.

Polymer composite material structures according to embodiments of the present invention show good absorbing properties while maintaining a high level of shielding for electromagnetic radiation in a large frequency region. In other words, the polymer composite material structure according to embodiments of the present invention behaves at the same time as an electromagnetic shield and as an absorbent. Also a foamed material is light in weight.

In an aspect of the present invention, a polymer composite material structure is provided comprising one layer of a foamed polymer composite material. The layer of foamed polymer composite material comprises a foamed polymer matrix and an amount of between 0.1 and 6 wt%, preferably between 0.5 and 4 wt% and more preferably between 0.5 and 2 wt% or between 0.5 and 1 wt%, of carbon based conductive loads dispersed in the foamed polymer matrix, which may preferably be an annealed foamed polymer matrix. According to embodiments of the present invention, the polymer composite material structure has a reflectivity of between -5 and -20 dB, preferably between -10 and -20 dB and most preferably between -15 and -20 dB. The reflectivity is a negative measure for the absorbing properties of the composite material. The lower the reflectivity is, the better the absorbing properties of the composite material can be. According to embodiments of the invention, the polymer composite material structure may have a shielding effectiveness of between 5 and 90 dB, preferably between 40 and 90 dB, more preferably between 60 and 90 dB and most preferably between 70 and 90 dB.

According to most preferred embodiments, whether foamed materials or otherwise, the carbon based conductive loads may be carbon nanotubes (CNTs). Preferably, the CNTs may be single-wall CNTs, double-wall CNTs, multi-wall CNTs or combinations thereof. Most preferably, the CNTs may be multi-wall CNTs. Preferably the CNTs are crude and/or purified.

The CNTs may be functionalised. According to embodiments of the invention, the CNTs may be modified by, for example, chemical modification, physical adsorption of molecules at the surface, metallization, or a combination thereof. Chemical modification of CNTs may, as known by a person skilled in the art, comprise grafting molecules to the CNT by e.g. plasma treatment or chemical treatment. The chemical modification of the CNTs comprises the use of, on the one hand, radical precursor molecules able to be grafted in a covalent way to the CNT and, on the other hand, molecules bearing conductive polymer moieties, such as e.g. thiophene, pyrrole, phenylene vinylene or benzene moieties (e.g. pyrene), able to adsorb/attach to the CNT by $\pi$-$\pi$ interaction.

According to other embodiments, commercially available functionalised CNTs may also be used. For example, amino-, hydroxyl-, carboxylic acid-, thiol- functionalised carbon nanotubes may be used. Some products are made available by Nanocyl SA under the commercial names Nanocyl ®-3152 for multi-wall carbon nanotubes surface modified by amino groups, Nanocyl ®-3153 for multi-wall carbon nanotubes surface modified by hydroxyl groups, Nanocyl ®-3151 and Nanocyl ®-3101 for multi-wall carbon nanotubes surface modified by carboxylic acid groups, and Nanocyl ®-3154 for multi-wall carbon nanotubes surface modified by thiol groups. These examples are not restrictive and other surface functionalised carbon nanotubes are made available by several carbon nanotubes companies and may be used with embodiments of the present invention.

Suitable polymers to be used with the present invention may preferably be polar polymers such as polyesters, polyacrylate, polymethacrylate, polyurethane and polycarbonates, and copolymers (atactic or block copolymers) comprising olefins (e.g. ethylene, propylene and derivatives) with acrylic or methacrylic monomers. Most preferably, the polar polymer used may be a polyester.

According to preferred embodiments of the invention, the polymer composite material structure may comprise a plurality of layers of polymer composite materials.

According to embodiments of the invention, the polymer composite material structure may comprise a plurality of layers of foamed polymer composite materials. Each layer of foamed polymer composite material comprises a foamed polymer matrix and an amount of between 0.1 and 6 wt%, preferably between 0.5 and 4 wt%, and more preferably between 0.5 and 2 wt% or between 0.5 and 1 wt%, of carbon based conductive loads or charges. Preferably, each layer of foamed polymer composite material may comprise a different amount of carbon based conductive loads or charges. For example, the polymer composite material structure may comprise a first layer of a foamed polymer composite material with a first amount of carbon based conductive loads or charges, a second layer of a foamed polymer composite material with a second amount of carbon based conductive loads or charges and a third layer of a foamed polymer composite material with a third amount of carbon based conductive loads or charges, the first, second and third amount of carbon

EP 1 930 364 A1

based conductive loads or charges being different from each other and being such that a concentration gradient of carbon based conductive loads or charges exists in the polymer composite material structure. An advantage of polymer composite material structures comprising such multilayer structures with a conductive load concentration gradient is that the good properties of the polymer composite material structures according to embodiments of the present invention as described above can be improved (see examples). It has to be understood that according to embodiments of the present invention multilayer structures may be formed comprising any other number of layers of foamed polymer composite material.

According to other embodiments of the invention, the polymer composite material structure may comprise at least one layer of a foamed polymer composite material and at least one layer of a non-foamed or solid polymer composite material. For example, the polymer composite material structure may comprise a first, second and third layer of polymer composite materials, the first and third layer comprising a foamed polymer composite material with a first, respectively second amount of carbon based conductive loads or charges and the third layer comprising a non-foamed or solid polymer composite material with a third amount of carbon based conductive loads or charges, at least one of the first, second and third amount of carbon based conductive loads being different from each other. According to other embodiments, the first, second and third amount of carbon based conductive loads or charges may be equal to each other. It has to be understood that according to these embodiments, the polymer composite material structure may comprise other configurations and other numbers of layers of foamed and non-foamed polymer composite materials.

By forming polymer composite material structures comprising multilayers of polymer composite materials with a concentration gradient in carbon based conductive loads, as described above, the good properties of the polymer composite material structures according to embodiments of the present invention as described above can be improved.

Another way for improving the properties of the polymer composite material structures according to embodiments of the invention is by combining CNTs and CB particles as carbon based conductive loads which are dispersed in the polymer matrix.

In another aspect of the invention, a method is provided for forming a polymer composite material structure. The method comprises providing at least one layer of a foamed polymer composite material. Providing at least one layer of a foamed polymer composite material comprises providing a polymer matrix, dispersing an amount of 0.1 to 6 wt%, preferably between 0.5 and 4 wt%, and more preferably between 0.5 and 2 wt% or between 0.5 and 1 wt%, of carbon based conductive loads into the polymer matrix, hereby forming a polymer composite material, foaming the polymer composite material and providing an annealed polymer composite material by annealing the polymer composite material before foaming or by annealing the foamed polymer composite material.

Annealing of the polymer composite materials results in polymer composite material structures with a reflectivity of between -5 and -20dB, preferably between -10 and -20dB and most preferably between -15 and -20 dB because it improves percolation or continuous network formation of the carbon based conductive loads inside the polymer matrix. Reflectivity is a negative measure for the absorbing properties of the polymer composite material structure. The lower the reflectivity is, the better the absorbing properties of the composite material structure can be. Because of the good reflectivity and absorptivity, the polymer composite material structures may have a shielding effectiveness of between 5 and 90 dB, preferably between 40 and 90 dB, more preferably between 60 and 90 dB and most preferably between 70 and 90 dB.

According to embodiments of the invention the method may furthermore comprise providing at least one further layer of a foamed polymer composite material and/or providing at least one layer of a non-foamed or solid polymer composite material.

According to embodiments of the invention providing at least one layer of a non-foamed or solid polymer composite material may comprise providing a polymer matrix, dispersing an amount of 0.1 to 6 wt%, preferably between 0.5 and 4 wt%, and more preferably between 0.5 and 2 wt% or between 0.5 and 1 wt%, of carbon based conductive loads hereby forming a polymer composite material, and may optionally comprising annealing the polymer composite material.

According to embodiments of the present invention, dispersion of carbon based conductive loads, e.g. CNTs, in the polymer matrix may comprise on the one hand, a reactive or non-extrusion process, i.e. an interfacial reaction between CNTs, which may, according to embodiments of the invention, preferably be functionalised. For example, the CNTs may be modified by e.g. chemical modification, physical adsorption of molecules at the surface, metallization, or a combination thereof, and the polymer matrix, or a simple mechanical tangle of CNTs with the polymeric chains, respectively and, on the other hand, a co-precipitation process wherein a solution containing the polymer and the CNTs are added to a non-solvent medium, e.g. to an aqueous solution, of the polymer. Also commercially available functionalised CNTs may be used. For example, amino-, hydroxyl-, carboxylic acid-, thiol- functionalised carbon nanotubes may be used. Some products are made available by Nanocyl SA under the commercial names Nanocyl ®-3152 for multiwall carbon nanotubes surface modified by amino groups, Nanocyl ®-3153 for multi-wall carbon nanotubes surface modified by hydroxyl groups, Nanocyl ®-3151 and Nanocyl ®-3101 for multi-wall carbon nanotubes surface modified by carboxylic acid groups, and Nanocyl ®-3154 for multi-wall carbon nanotubes surface modified by thiol groups. These examples are not restrictive and other surface functionalised carbon nanotubes are made available by several carbon nanotubes companies and may be used with embodiments of the present invention.

Foaming of the formed polymer composite materials may be performed by the use of a physical or a chemical foaming agent.

Physical foaming agents such as e.g. molecular nitrogen and carbon dioxide ($CO_2$) are gaseous agents. These gases are soluble in particular molten state polymers under high pressure. By depressurising the system in which foaming is performed, a combination of nucleation and bubble growth generates a cellular structure in the composite material. The use of e.g. $CO_2$ in a supercritical state, i.e. a fluid having an intermediate behaviour between gas and liquid state, presents many advantages, in particular non-toxicity compared to chemical foaming agents (see further) since no solid residues or toxic gases are produced in the foamed structure. Moreover, the inert nature of gas confers foaming at very low temperatures under safety conditions. The dissolution of $CO_2$ in the polymer matrix (before its expansion) also gives rise to a drop of the transition temperature or melting temperature of the polymer (Tg or Tm). In this way, the process with $CO_2$ can be implemented at temperatures lower than the initial Tg or Tm, hereby making foaming of thermosensitive matrixes also possible.

Examples of chemical foaming agents may be porogene agents such as e.g. azodicarbonamide, which are generally used in the form of powders which decompose at relatively high temperatures, e.g. typically 170°C for azodicarbonamide, in the presence of a decomposition accelerating agent or decomposition catalyst such as e.g. zinc oxide and/or zinc stearate. The amount of foaming agent, expressed in weight percent compared to polymer, may be between 5 and 20%, and preferably between 10 and 15%. The amount of decomposition catalyst, expressed in weight percent compared to polymer, may preferably be between 1 and 10%, and more preferably between 3% and 5%.

In case of, e.g. polyurethane foams, traditional foaming processes known by a person skilled in the art, may be used. An example of a foaming process is described in EP 0 930 323. Polyurethane foams loaded CNTs are in this document prepared by reaction between one or more diols or polyols and one or more polyisocyanates. CNTs are dispersed in the liquid precursors or in solution before polymerisation and foaming. An ultrasonic treatment could be applied to the solution in order to improve the dispersion of the CNTs.

Suitable low molecular weight diols or polyols which may be applied with the method according to embodiments of the invention may be short chain diols or polyols containing from 2 to 20 aliphatics, araliphatics or cycloaliphatics carbons. Examples of diols are ethylene glycol, diethylene glycol, triethylene glycol, tetraethylene glycol, dipropylene glycol, tripropylene glycol, 1,2-propanediol, 1,3-propanediol, 1,4-butanediol, 1,4-butanediol, neopentyl glycol, 2-ethyl-2-butylpropanediol, trimethylpentanediol, the isomers of diethyloctanediol, 1,3-butylene glycol, cyclohexanediol, 1,4-cyclohexanedimethanol, 1,6-hexanediol, 1,2- and 1,4-cyclohexanediol, hydrogenated bisphenol A (2,2-bis(4-hydroxy-cyclohexy- l)propane), 2,2-dimethyl-3-hydroxypropyl, 2,2-dimethyl-3-hydroxypropionate. Examples of triols are trimethylolethane, trimethylolpropane or glycerol. Examples of polyols are ditrimethylolpropane, pentaerythritol, dipentaerythritol and sorbitol. Preferable diols or polyols are 1,4-butanediol, 1,4-cyclohexanedimethanol, 1,6-hexanediol and trimethylol propane.

According to other embodiments, also higher molecular mass polyols may be used, such as e.g. polyester polyols, polyether polyols, hydroxy-functional (meth)acrylate (co)polymers, hydroxy-functional polyurethanes or corresponding hybrids (see 'Rompp Lexikon Chemie, p. 465-466, 10th ed. 1998, Georg-Thieme-Verlag, Stuttgart').

According to still other embodiments, mixtures of diisocyanates or polyisocyanates may also be used. Polyisocyanates may be aromatic, araliphatic, aliphatic or cycloaliphatic di- or polyisocyanates. Examples of suitable diisocyanates or polyisocyanates which may be used with the method according to embodiments of the invention may be butylene diisocyanate, hexamethylene diisocyanate (HDI), isophorone diisocyanate (IPDI), 2,2,4-and/or 2,4,4-trimethylhexamethylene diisocyanate, the isomeric bis (4,4'-isocyanatocyclohexyl)methanes or mixtures thereof of any desired isomer content, isocyanatomethyl-1,8-octane diisocyanate, 1,4-cyclohexylene diisocyanate, the isomeric cyclohexanedimethylene diisocyanates, 1,4-phenylene diisocyanate, 2,4- and/or 2,6-tolylene diisocyanate, 1,5-naphthylene diisocyanate, 2,4'- or 4,4'-diphenylmethane diisocyanate, triphenylmethane-4,4',4"-triisocyanate or derivatives thereof with a urethane, urea, carbodiimide, acylurea, isocyanurate, allophanate, biuret, oxadiazinetrione, uretdione, iminooxadiazinedione structure and mixtures thereof.

In making, for example, polyurethane foams, it may generally be preferred to add an amount of a surfactant to stabilize the foaming reaction mixture until it cures. All surfactants used for stabilizing polyurethane foams known by a person skilled in the art can be used with the present invention. Examples of surfactants which may be used may advantageously comprise a liquid or solid organosilicone surfactant. For example, silicone surfactants may be used with the method according to the present invention. These silicone surfactants may, for example, include "hydrolysable" polysiloxane-polyoxyalkylene block copolymers; "non-hydrolysable" polysiloxane-polyoxyalkylene block copolymers; Polysiloxane-polycaprolactone block copolymers, cyanoalkylpolysiloxanes; alkylpolysiloxanes; polydimethylsiloxane oils. The type of silicone surfactant used and the amount required depends on the type of foam produced as known by those skilled in the art. Silicone surfactants can be used as such or can be dissolved in solvents such as, for example, glycols.

The use of a foam structure allows to decrease the dielectric constant of the polymer matrix. The dielectric constant will be close to unity because of the volume of air contained in the foam. This air contained in the foam structure constitutes means to minimise the reflection of the signal and thus to achieve good electromagnetic absorbers.

The method according to embodiments of the invention provides controlled dispersion and concentration of CNTs in the polymer matrixes.

Summarized, the use of foams allows a penetration of the electromagnetic waves within the material hereby lowering the dielectric constant and adequate shaping of the input interface, while a control of the dispersion and the concentration of CNTs, using the process according to embodiments of the invention as described above, allows to maximise the absorption of the electromagnetic waves inside the composite with very weak concentrations in nanotubes, so as to minimise the residual signal detected after the composite shield. The limitation of electromagnetic interferences observed by using the composite materials according to embodiments of the invention is due to the combination of two properties obtained simultaneously with the same composite material: the shielding property, by the reduction/removal of any signal detected after the electromagnetic shield, and the microwave absorbing property, to reduce/remove any reflection of the incident electromagnetic waves on the composite.

When using discrete conductive materials loaded into an insulating matrix, percolation or continuous network formation is of importance. In order to improve percolation or continuous network formation of carbon based conductive loads, e.g. CNTs, inside the polymer matrix, after dispersion of the carbon based conductive loads in the polymer matrix, the thus formed polymer composite materials are annealed. Preferably, annealing may be performed at a temperature equal to or higher than the glass transition temperature (Tg) of the polymer used in case of amorphous polymers, and equal to or higher than the melting point (Tm) of the polymer in case of semi-crystalline polymers. Annealing of the polymer composite materials results in polymer composite material structures with a reflectivity of between -5 and -20dB, preferably between -10 and -20dB and most preferably between -15 and -20 dB because it improves percolation or continuous network formation of the carbon based conductive loads inside the polymer matrix. Reflectivity is a negative measure for the absorbing properties of the polymer composite material structure. The lower the reflectivity is, the better the absorbing properties of the composite material structure can be. Because of the good reflectivity and absorptivity, the polymer composite material structures may have a shielding effectiveness 5 and 90 dB, preferably between 40 and 90 dB, more preferably between 60 and 90 dB and most preferably between 70 and 90 dB.

The profile or shape of the polymer composite material structure according to embodiments of the present invention can be optimised in order to minimise the reflection of the incident electromagnetic waves on the surface of the composite material, for example, by manufacturing cone- or pyramid-shaped materials for e.g. anechoic chambers or easily processing or moulding by simple foam cutting.

Besides material and weight saving associated with the low density of these composite material structures according to embodiments of the invention and the advantages with regard to electromagnetic performances as described above, the polymer composite material structures according to embodiments of the present invention also show specific functionalities such as e.g. heat insulation, acoustic, vibrations absorption and flame retardant, which make them also suitable to be used as coating materials in many applications such as housing, electronics, cars, ..., directly concerned with the problems of electromagnetic pollution. Moreover, from a technological point of view, the dispersion of CNTs within the honeycombed structure of expanded polymers must lead to real synergies. On the one hand, the size modification in the foamed polymer matrix (lamellar morphology of the polymer separating the gas-charged cells) must enhance the percolation of the CNTs and reduce the load factor or concentration of CNTs. In addition, CNTs, from their nanoscopic size and their very high aspect ratio, will contribute to reinforce the melt strength of the polymer and to enhance the nucleation of the cells, for the benefit of a higher homogeneity of the polymer foam.

Hereinafter some examples will be described to illustrate different ways for forming polymer composite material structures according to embodiments of the invention. First, methods for forming the particular composite material structures will be described. In a second part, the products obtained will be discussed and compared to known composite materials. The examples will mainly be described for the polymer being a polyester (e.g. polycaprolactone) and a polyethylene terpolymer having functional groups such as e.g. maleic anhydride, acrylic ester, glycidyl methacrylate. It has, however, to be understood that these examples are not intended to limit the invention in any way. Any suitable foamable polymer, as described above, can be used according to embodiments of the present invention.

Example 1: formation CNT/polycaprolactone (PCL) composite material structures by melt mixing

Composite material structures are prepared by melt mixing of 4g of polycaprolactone (CAPA© 6500, Mn = 50,000 g/mol) and 40 mg CNTs Thin with an average external diameter of 10 nm and a purity up to 95 wt% (produced by Catalytic Carbon Vapour Deposition or CCVD and obtainable from "Nanocyl S.A.") in a 5 cm³ extruder (MIDI 2000 DSM) at 80°C for 10 minutes at 200 rpm. The mix is then pelletized (15 mm x 25 mm X 35 mm) with a moulding press (Fontijn type) at 90°C and under a pressure of 80 bar during 5 minutes for the determination of electromagnetic wave absorbing properties. The composite materials structures are then annealed at a temperature of 180°C or, in other words, at a temperature higher than the melting point of the PCL polymer (T > Tm of PCL) during several hours.

Comparative example 1: formation of polycaprolactone (PCL) composite materials by melt mixing

The same material is formed as in Example 1, but without addition of CNTs. Herefore, 4g of polycaprolactone (CAPA© 6500, Mn = 50,000 g/mol) is introduced in a 5cm³ extruder (MIDI 2000 DSM) at 80°C and 200 rpm during 10 minutes. The polymer is then pelletized (15 mm x 25 mm X 35 mm) with a moulding press (Fontijn type) at 90°C under a pressure of 80 bar during 5 minutes for the determination of electromagnetic wave absorbing properties.

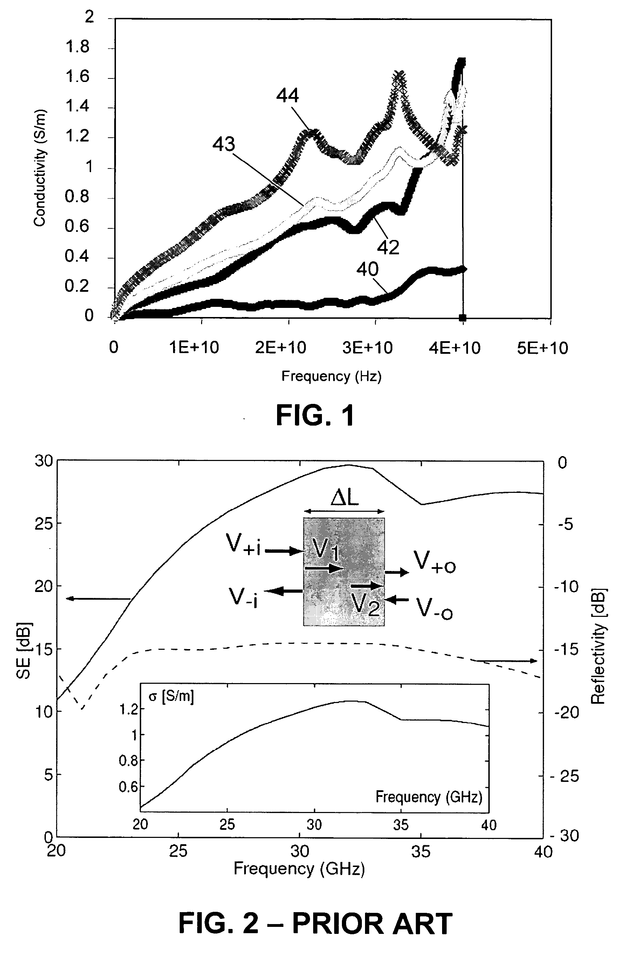

Fig. 1 shows that the conductivity for a CNT/polycaprolactone with 1wt% CNTs (curve 41 in Fig. 1) is higher than the conductivity for a pure polycaprolactone polymer (see curve 40 in Fig. 1). Furthermore, Fig. 1 shows that already after 1 hour of annealing (see curve 42 in Fig. 1) the conductivity of the CNT/polycaprolactone composite structure with 1wt% CNT has a slightly higher conductivity than when it is not annealed, but that after 15 hours of annealing the conductivity is clearly improved. This is because annealing improves percolation or continuous network formation of CNTs inside the polymer matrix.

Example 2 : formation of CNT/polycaprolactone (PCL) composite material structures by co-precipitation

In a first step, 10g of polycaprolactone (CAPA© 6500, Mn = 50,000 g/mol) is dissolved in 400ml of THF. Then, 100 mg CNTs Thin with an average external diameter of 10 nm and a purity up to 95 wt% (formed by Catalytic Carbon Vapour Deposition or CCVD and obtainable from "Nanocyl S.A.") are dispersed in the solution. An ultrasonic treatment is applied during 30 minutes to enhance the CNT dispersion in the solution. The composite materials are prepared by adding the solution with dispersed CNTs in 400ml of heptan. The mix is then pelletized (15 mm x 25 mm x 35 mm) with a moulding press (Fontijn type) at 90°C, under a pressure of 80 bar during 5 minutes for the determination of electromagnetic wave absorbing properties.

Comparative example 2: formation of polycaprolactone (PCL) composite materials by co-precipitation

The same material is formed as in Example 2, but without addition of CNTs. In a first step, 10g of polycaprolactone (CAPA© 6500, Mn = 50,000 g/mol) are added to 400 ml of THF. An ultrasonic treatment is applied for 30 minutes. The solution is added to 400ml of heptan. The polymer is then pelletized (15 mm x 25 mm x 35 mm) with a moulding press (Fontijn type) at 90°C, under a pressure of 80 bar during 5 minutes for the determination of electromagnetic wave absorbing properties.

Example 3: foaming of CNT/polycaprolactone (PCL) composite material structures in a chemical way

In a first step, 3.6g of CNT/polycaprolactone composite material structure, prepared according to the procedure described in Example 1 or 2, 0.288g of azodicarbonamide (ADC FC2, obtainable from Bayer) used as foaming agent and 0.096g of zinc (ZnO 2C, Silox) used as decomposition accelerating agent for the azodicarbonamide are mixed in a 5cm³ extruder (MIDI 2000 DSM) at 80°C for 10 minutes at 200rpm. Then, the materials are pelletized (8 mm x 25 mm x 35 mm) with a moulding press (Fontijn type) at 90°C, under 80 bar during 5 minutes. The composite material structure is then heated up to 170°C for 7 minutes in a conventional drying oven to produce the foamed composite material structures which are finally pelletized (15 mm x 25 mm x 35 mm) for the determination of electromagnetic wave absorption properties.

Comparative example 3: foaming of polycaprolactone (PCL) in a chemical way

In a first step, 3.6g of polycaprolactone (CAPA© 6500, Mn = 50,000 g/mol), 0.288g of azodicarbonamide (ADC FC2, Bayer) used as foaming agent and 0.096g of zinc (ZnO 2C, Silox) used as decomposition accelerating agent are mixed in a 5cm³ extruder (MIDI 2000 DSM) at 80°C for 10 minutes at 200rpm. Then, the materials are pelletized (8 mm x 25 mm X 35 mm) with a moulding press (Fontijn type) at 90°C, under 80 bar during 5 minutes. The mixtures are foamed in a conventional drying oven at 170°C for 7 minutes. The foams obtained are pelletized (15 mm x 25 mm x 35 mm) for the determination of electromagnetic wave absorption properties.

Example 4: foaming of CNT/polycaprolactone (PCL) composite material structures using supercritical $CO_2$ (in a physical way)

CNT/polycaprolactone composite materials prepared following the procedure described in Examples 1 or 2 are pelletized (8 mm x 25 mm X 35 mm) with a moulding press (Fontijn type) at 90°C, under 80 bar for 5 minutes. A pellet is then introduced in a high pressure reactor and $CO_2$ is injected using a high pressure syringe pump (model ISCO 260D) until a pressure of 60 bar is reached. After a saturation temperature of about 50 à 60°C has been reached, a new pressurisation step may be performed at a saturation pressure of about 250. After 3 hours (saturation time), the reactor is depressurised at a predetermined rate (decompression time). Foams are recovered, characterized and pelletized (15 mm x 25 mm x 35 mm) for the determination of electromagnetic wave absorption properties.

Comparative example 4: foaming of polycaprolactone (PCL) using supercritical $CO_2$ (in a physical way)

Polycaprolactone (CAPA© 6500, Mn = 50,000 g/mol) is pelletized (8 mm x 25 mm x 35 mm) with a moulding press (Fontijn type) at 90°C at a pressure of 80 bar for 5 minutes. A pellet is then introduced in a high pressure reactor and $CO_2$ is injected using a high pressure syringe pump (model ISCO 260D), until 60 bar. The desired temperature is fixed at a saturation temperature of 50 to 60°C before proceeding to a new pressurisation step of the reactor (saturation pressure : 250 bars). After 3 hours (saturation time), the reactor is depressurised at a predetermined rate (decompression time). Foams are recovered, characterized and pelletized (15 mm x 25 mm x 35 mm) for the determination of electromagnetic wave absorption properties.

Example 5: formation of CNT/polyethylene-co-octene composite material structures by melt mixing

CNT/polyethylene-co-octene composite materials have been prepared by melt mixing of 4g of polyethylene-co-octene (Engage 8400 obtainable from Dupont Dow Elastomers) and 40 mg CNTs Thin with an average external diameter of 10 nm and a purity up to 95 wt% (made by Catalytic Carbon Vapour Deposition CCVD an obtainable from "Nanocyl S.A.") in a 5cm$^3$ extruder (MIDI 2000 DSM) at 90°C for 10 minutes at 200rpm. The mixture is pelletized (15 mm x 25 mm X 35 mm) with a moulding press (Fontijn type) at 90°C at a pressure of 80 bar for 5 minutes for the determination of electromagnetic wave absorption properties.

Comparative example 5: formation of polyethylene-co-octene materials by melt mixing

4g of polyethylene-co-octene (Engage 8400 Dupont Dow Elastomers) have been introduced in a 5cm$^3$ extruder (MIDI 2000 DSM) at 80°C for 10 minutes at 200rpm. The polymer is then pelletized (15 mm x 25 mm X 35 mm) with a moulding press (Fontijn type) at 90°C at a pressure of 80 bar for 5 minutes for the determination of electromagnetic wave absorption properties.

Hereinafter, the properties of the products obtained in the above examples will be discussed and will be compared to similar, known foamed and solid (non-foamed) products.

Evaluation test 1: Evaluation of microwave shielding and absorbing properties

Preliminary tests achieved with solid or non-foamed products, have highlighted the shielding and absorbing properties of composite materials containing CNTs and polycaprolactone (PCL) [see A. Saib et al., IEEE Trans. on Microwave theory and techniques, vol. 54 (6), June 2006].

The few recent results presented in the literature concerning the EMI shielding using nanofibres [Yang et al., Adv. Mat., 2005 (17) p.1999-2003] or carbon nanotubes [Yang et al., Nano Letters, 2005, 5(11) p.2131-2134] disclose composite materials having electromagnetic shielding properties obtained by maximisation of the reflected power at input interface. However, these composite materials do not show good absorption properties. In other words, these materials are good electromagnetic radiation shields, because they reflect all the incident power at input interface so that no signal goes through, but they are poor absorbents.

For the CNT/polymer composite material structures according to embodiments of the invention, a reflectivity (R) lower than -15 dB has been observed combined with a shielding effectiveness (SE) of about 15 dB/cm, which is in the range of values given for the available commercial products (SE = 0.4→19 [dB/cm], |R |=15→20 [dB], [see Laird Technologies, "RF products - Microwave absorbing materials"]) and higher than the reflectivity (|R |=1.8dB) obtained by Yang and al. [Nano Letters, 2005, 5(11) pp 2131-2134]. It should, however, be noted that these commercial products are foamed composites with a concentration of conductive loads (carbon black, carbon fibre) of about 10%.

Similar performances were obtained for solid or non-foamed CNT/polymer composite materials obtained with the process according to the present invention, the composite materials having a concentration of CNTs of 0.5% which is 20 times lower than the composite materials described by Yang et al. [see A. Saib et al., IEEE Trans. on Microwave theory and techniques, vol. 54 (6), June 2006].

This is illustrated in Fig. 2 which shows the shielding effectiveness (SE, full line) and the reflectivity (R, based on conductivity measurements (see insert), dashed line) as a function of frequency for a solid (non-foamed) composite material comprising 0.5 weight percent (wt%) CNTs. A first insert of Fig. 2 (upper part of figure) illustrates the difference between two concepts: it shows the voltage magnitude of incident (subscript +) and reflected (subscript -) waves at input (I) and output (o) interfaces between air and composite material, as well as waves V1 and V2 present in the material at those interfaces. Referring to the notation in this insert, the power absorption (PA) is a measure of the decay undergone by signal flowing through a composite material of thickness $\Delta L$, from just after the input interface (air-material) till just before the output interface (material-air), and is not influenced by the reflections at such interfaces:

$$PA = 20 \log_{10} |V_1/V_2|$$

The shielding effectiveness is defined as the ratio between power incident in air at the input interface and power detected in air at the output interface:

$$SE = 20 \log_{10} |V_{+i}/V_{+0}|_{v\text{-}0=0}$$

Shielding efficiency thus results from the combination of power absorption inside the material and reflection of power at the input interface. It is usually defined or measured assuming no reflection in the output air medium ($V_{-0} = 0$).

Another parameter of interest for characterising the composite materials is the reflectivity R. It measures the efficiency of the composite material as a microwave absorber that is presenting a low reflection coefficient at the input interface. The reflectivity is defined as the ratio between reflected and incident wave at the input air interface obtained when backing the output interface by a metal plate, acting as a perfect reflector:

$$R = 20 \log_{10} |V_{-i}/V_{+i}|_{v\text{-}0=\text{-}v+0}$$

Form Fig. 2 it can be seen that a reflectivity of about -15 dB is obtained and a shielding effectiveness of between 11 and 29 dB.

A second input in Fig. 2 (lower part of figure) shows the conductivity $\sigma$ as a function of frequency. A conductivity of about 1 S/m is obtained for the solid (non-foamed) composite material comprising 5 wt% CNTs, which corresponds with a shielding efficiency of about 13 dB/cm.

Better performances are expected for composite material structures comprising at least one layer of foamed polymer composite material or comprising at least one layer of foamed polymer composite material and at least one layer of non-foamed polymer composite material according to the present invention (see further).

Comparative evaluation test 1

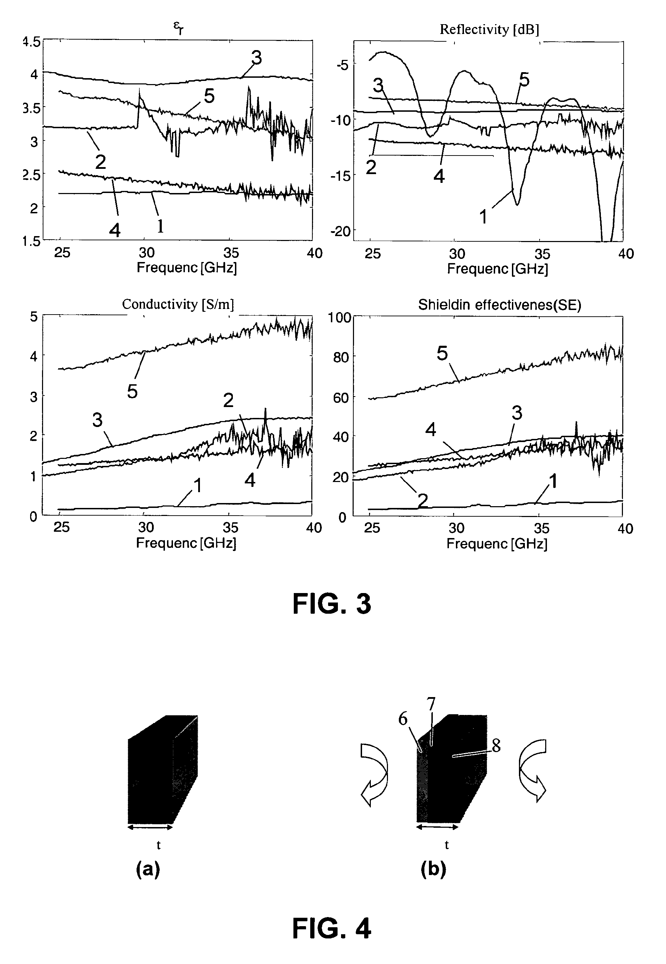

Fig. 3 and table 1 compare the performances of foamed and solid (non-foamed) products. A low level of conductivity has been observed for pure polycaprolactone (PCL) (see curves indicated with reference number 1 in Fig. 3), indicating that the polymer itself is not suitable for being used as a shield for electromagnetic radiation because it has poor shielding and reflectivity properties, as can also be seen from Fig. 3.

The addition of CNTs in the polycaprolactone matrix (curves indicated with reference number 2 (0.16 vol% or 0.33 wt% CNTs) and reference number 3 (0.5vol% or 1wt% CNTs) in Fig. 3) allows to increase the conductivity, and therefore also the shielding effectiveness, and to a certain extent, to decrease the reflectivity. However, the reduction of reflectivity is not optimal because the addition of CNTs increases the permittivity, which contributes to increase the reflection of the signal or electromagnetic wave at the input surface of the composite material.

Table1: values for the dielectric constant, conductivity, shielding effectiveness and reflectivity obtained at 30 GHz for foamed and solid (non-foamed) products.

| Sample | Dielectric constant ($\varepsilon_r$) | Conductivity ($\sigma$) (S/m) | Shielding effectiveness (SE) dB | Reflectivity (dB) |
|---|---|---|---|---|
| PCL Pure | 2.21 | 0.18 | 4.20 | -6.15 |

(continued)

| Sample | Dielectric constant ($\varepsilon_r$) | Conductivity ($\sigma$) (S/m) | Shielding effectiveness (SE) dB | Reflectivity (dB) |
|---|---|---|---|---|
| PCL solid + 0.16 vol% or 0.33wt% CNTs | 3.15 | 1.40 | 24.2 | -10.5 |
| PCL solid + 0.5 vol% or 1wt% CNTs | 3.84 | 1.90 | 31.7 | -9.35 |
| PCL foam + 0.107 vol% or 1 wt% CNTs | 2.38 | 1.40 | 28.0 | -12.25 |
| PCL foam + 0.25 vol% or 2 wt% CNTs | 3.48 | 4.09 | 67.2 | -8.50 |

On the other hand, better results have been obtained with the CNT/polycaprolactone foam composite materials according to the present invention. It can be seen from Fig. 3 that the reflectivity is much improved. A foamed CNT/polycaprolactone composite material containing 0.107 vol% or 1 wt % of CNTs (see curve with reference number 4 in Fig. 3) has a conductivity close to that of a non-foamed sample containing 0.16 vol% or 0.33 wt % of carbon nanotubes (curve 2 in Fig. 3), and thus involves a comparable shielding effectiveness.

On the other hand, the dielectric constant of the polymer composite material structures according to the present invention is quite lower. This is because of the increase of the permittivity induced by the presence of CNTs is compensated by the presence of a large quantity of air in the foam, which contributes to bring back the permittivity of the foamed composite to a value close to the one for pure polycaprolactone (see curve 1). The result is that, with about an identical concentration in CNTs, the reflectivity of the foamed product is lower than the one of a non-foamed product.

Beyond a certain threshold of concentration of CNTs, the conductivity obtained for a polymer composite material structure comprising at least one layer of a foamed polymer composite material according to the present invention is higher than the conductivity of a non-foamed composite material. This is because the dispersion, and thus the percolation, occurs more easily within the foamed product. Thus, the conductivity of a foamed composite material comprising 0.25 vol% or 2 wt% of CNTs (see curve 5 in Fig. 3) is twice higher than the conductivity of a solid (non-foamed) product containing 0.5 vol% or 1 wt of CNTs (curve 3). The same comment holds for the shielding effectiveness. On the other hand, thanks to the presence of air in the foamed composite material structures, dielectric constants remain in the same order of magnitude, which involves comparable levels of reflectivity, in spite of a higher conductivity of the foamed composite materials.

Evaluation test 2

According to embodiments of the invention, the foamed composite materials may be formed such that a CNT concentration gradient is present in the composite material.

Experimental tests are performed with foamed polycaprolactone composite materials comprising respectively 0.5 wt% or 0.049 vol%, 1 wt% or 0.107 vol% and 2 wt% or 0.25 vol% of CNTs. The topology is illustrated in Fig. 4(a) and 4(b). Fig. 4(a) shows a monolayer of the composite material according to embodiments of the present invention. The monolayer may, according to this example, have a thickness of 3 cm. Tests were performed to such monolayers of composite material comprising 0.5 wt% or 0.049 vol%, 1 wt% or 0.107 vol% and 2 wt% or 0.25 vol% of CNTs. Fig. 4(b) shows a tri-layer composite material structure according to the present invention, the tri-layer comprising a first layer 6 of composite material having a thickness of e.g. 10 mm and comprising 0.5 wt% or 0.049 vol%, CNTs, a second layer 7 of composite material having a thickness of e.g. 2 mm and comprising 1 wt% or 0.107 vol% of CNTs and a third layer 8 of composite material having a thickness of e.g. 17 mm and comprising 2 wt% or 0.25 vol% of CNTs. Hence, the average content of CNTs in the tri-layer composite material structure having a thickness of, in the example given, 29 mm or 2.9 cm may be about 1.3 wt% or 0.17 vol%.

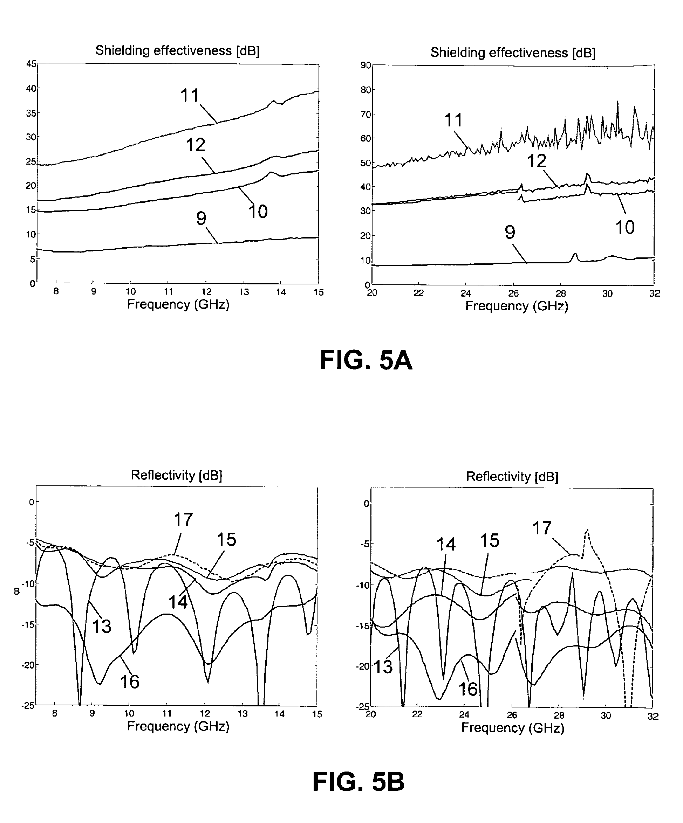

Fig. 5A shows the shielding effectiveness for the monolayer comprising the polycaprolactone (PCL) based composite material formed by co-precipitation and having a thickness of 3 cm and comprising 0.5 wt% or 0.049 vol%, CNTs (curve 9), 1 wt% or 0.107 vol% CNTs (curve 10) and 2 wt% or 0.25 vol% CNTs (curve 11) and for a PCL based composite material formed of a tri-layer composite material structure as illustrated in Fig. 4(b) and having a thickness and CNT distribution as described above (curve 12) for two different frequency ranges, i.e. for a first frequency range between 7 and 15 GHz (graph on the left hand side) and for a second frequency range between 20 and 32 GHz (graph on the right hand side).

It can be seen from Fig. 5A that, when the concentration of CNTs in the composite material increases, the shielding effectiveness (SE) also increases. This is because the power of the signal or electromagnetic wave is more absorbed in the conducting composite and thus the reflectivity is degraded (- 9dB max for 0.25 vol% CNTs, curve 15 in Fig. 5B). This can be seen from Fig. 5B which shows the reflectivity for a foamed polycaprolactone (PCL) based composite material formed of a monolayer having a thickness of 3 cm and comprising 0.5 wt% or 0.049 vol%, CNTs (curve 13), 1 wt% or 0.107 vol% CNTs (curve 14) and 2 wt% or 0.25 vol% CNTs (curve 15) and for a PCL based composite material formed of a tri-layer composite material structure as illustrated in Fig. 4(b) and having a thickness and CNT distribution (0.049/0.107/0.25 vol%) as described above (curve 16) and a tri-layer composite material structure having a 0.25/0.107/0.049 vol%, CNT distribution (curve 17). Again, the reflectivity is shown for two different frequency ranges, i.e. for a first frequency range between 7 and 15 GHz (graph on the left hand side) and for a second frequency range between 20 and 32 GHz (graph on the right hand side).

If a tri-layer structure is used (topology as illustrated in Fig. 4(b)), each layer having different concentration and thickness, it is possible to obtain a good shielding effectiveness which is higher than 20 dB for frequencies higher than 10 GHz, while preserving a reflectivity lower than - 15 dB, i.e. better than the reflectivity obtained with the monolayer of foamed composite material. It should be noted that the tri-layer structure has the same overall thickness as the monolayer and an average concentration of CNTs of 1.3 wt% or 0.17 vol%. An equal or higher shielding effectiveness may be obtained compared to the monolayer with a concentration of 1 wt% or 0.107 vol% of CNTs, while maintaining a reflectivity lower than that obtained for 0.5, 1 and 2 wt% or respectively 0.049, 0.107 and 0.25 vol% of CNTs.

Moreover, it is observed that the reflectivity is not symmetrical in the case of a tri-layer structure. Curve 16 corresponds to the measured reflectivity when the signal is incident on layer 6 of the tri-layer structure as illustrated in Fig. 4(b) having the lowest concentration of CNTs (i.e., in the example given, 0.5 wt% or 0.049 vol%,) while curve 17 gives the reflectivity when the signal is incident on layer 8 having the highest concentration of CNTs (i.e., in the example given, 2 wt% or 0.25 vol%). Thus, from this it can be concluded that the absorption properties of the composite material in case of multi-layer structures depend on what side is exposed to the incident signal.

The above discussion is about tri-layer structures. It has to be noted, however, that this is only for the ease of explanation and that in general multi-layer structures comprising any suitable number of different layers are also disclosed in this application, e.g. four layers, five layers, six layers, etc.

The above illustrates that a control of the CNT concentration gradient and the thickness of the different layers may allow optimising the performances of the composite material structure while still maintaining a low load factor or a low concentration in carbon based conductive loads, in the example given CNTs.

The performances should be better if instead of a tri-layer structure, one refined the gradient of concentration by using finer layers of different concentration.

It has to be noted that the discontinuity observed in the curves around 26 GHz is explained by a change of set-up of the measurement at that frequency.

Evaluation test 3

The above results relate to foamed polycaprolactone (PCL) matrixes wherein the CNTs are included by co-precipitation.

Hereinafter, some results will be discussed with respect to polycaprolactone (PCL) based composite materials wherein CNTs were included by melt-blending or extrusion. Experiments were performed on monolayers of PCL based foamed composite material having a thickness of 2 cm and comprising 1 wt% or 0.1 vol% of CNTs, 2 wt% or 0.222 vol% of CNTs and 4 wt% or 0.541 vol% of CNTs. The results of these experiments are compared to the experiments performed on a tri-layer of PCL based foamed composite materials, the tri-layer having a total thickness of 29 mm and comprising a first layer with a thickness of e.g. 2 mm and 1 wt% or 0.1 vol% CNTs, a second layer with a thickness of e.g. 10 mm and 2 wt% or 0.222 vol% CNTs and a third layer with a thickness of e.g. 17 mm and 4 wt% or 0.541 vol% CNTs.

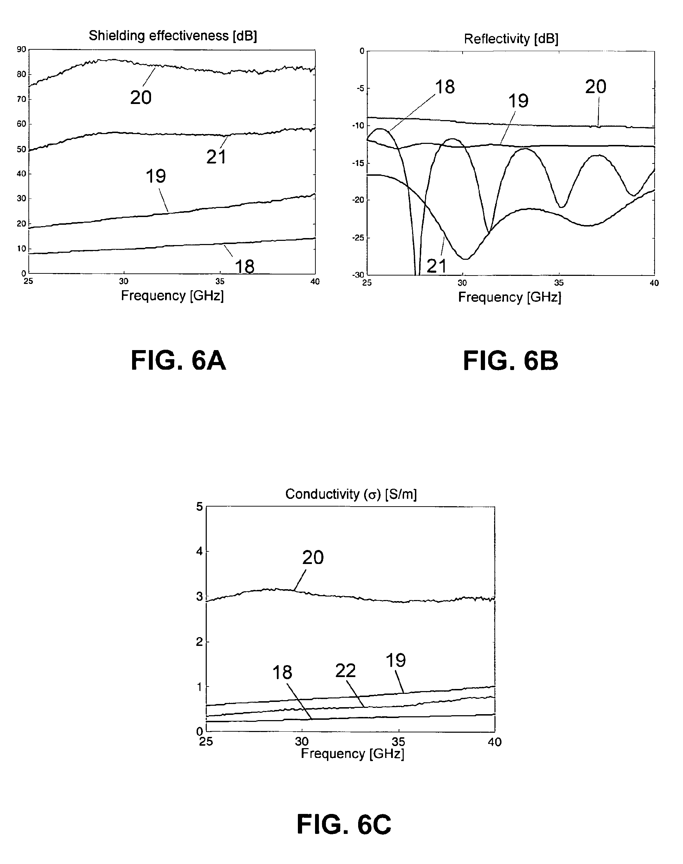

Fig. 6A and 6B respectively show the shielding effectiveness and reflectivity for monolayers comprising carbon nanotube/PCL foam composite material formed by melt-blending or extrusion and with 1 wt% or 0.1 vol% CNTs (curve 18), 2 wt% or 0.222 vol% percent CNTs (curve 19) and 4 wt% or 0.541 vol% CNTs (curve 20) and for a tri-layer having a thickness of 29 mm and having a CNT distribution as described above (curve 21).

From Fig. 6A and 6B it can be seen that similar performances can be obtained with foamed composite materials based on a carbon nanotube/PCL composite obtained by melt-blending or extrusion (Fig. 6A and 6B) compared to carbon nanotube/PCL composite material obtained by co-precipitation (Fig. 5A and 5B). Levels of conductivity higher than 1 S/m are measured starting from a sufficient concentration of about 4 wt% or 0.541 vol% CNTs, which imply some excellent performances of the tri-layer device: shielding effectiveness SE >50 dB, reflectivity R < -15 dB. It can be seen From Fig. 6C that for composite materials comprising a CNT concentration of 1 wt% or 0.1 vol% and 2 wt% or 0.222 vol% (see respectively curve 18 and 19), the conductivity is lower than 1 S/m but that for composite materials comprising a CNT concentration of 4 wt% or 0.541 vol% (see curve 20) a conductivity of about 3 S/m can be obtained. The results for the foamed composite materials according to embodiments of the present invention are compared to a solid (non-foamed) polymer, e.g. Lotader®, with a CNT concentration of 2 wt% (see curve 22). It can be seen that the conductivity of such composite materials is lower than for foamed composite material according to embodiments of the present invention comprising a same 2 wt% or 0.222 vol% CNTs.

Evaluation test 4

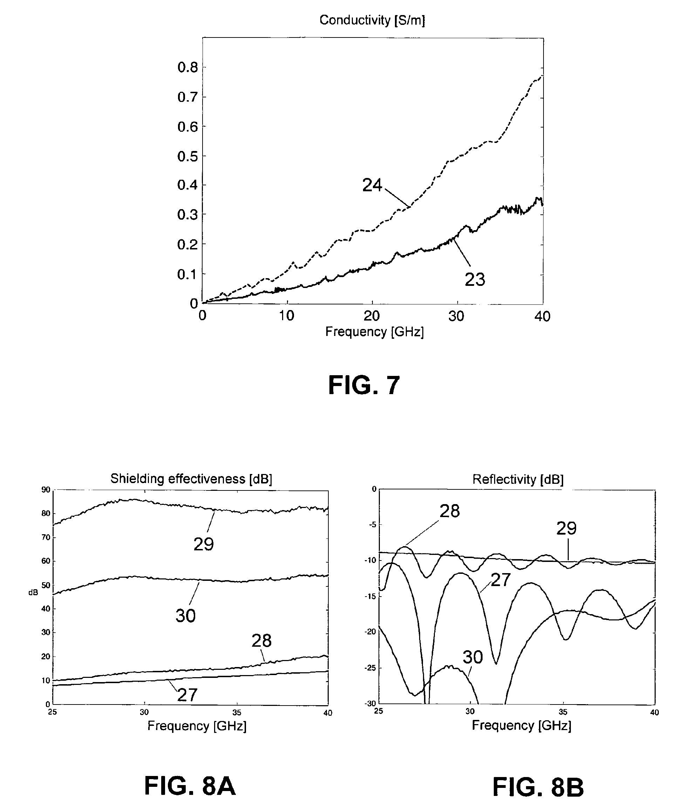

The results obtained and described above are not limited by the polymer used. Other polar polymers, such as for example Lotader®, can be used according with the present invention. Lotader® 4700 resin is a random terpolymer of Ethylene, Ethyl Acrylate and Maleic Anhydride.Mixtures containing CNTs (Thick type obtainable from Nanocyl S.A.) and Lotader® 4700 (obtainable from Atofina- Arkema) were carried out by extrusion in a twinscrew extruder (DSM 15cm$^3$).
The processing conditions are as follows: 15 minutes with 100°C at 100 or 250 rpm followed by annealing for 2 hours. Annealing allows to improve the conductivity of the composite, as shown in Fig. 7 which shows the conductivity for a composite material comprising Lotader® 4700 polymer and 2 wt% CNTs without annealing (curve 23) and after annealing for 2 hours (curve 24).

Comparative evaluation test 3

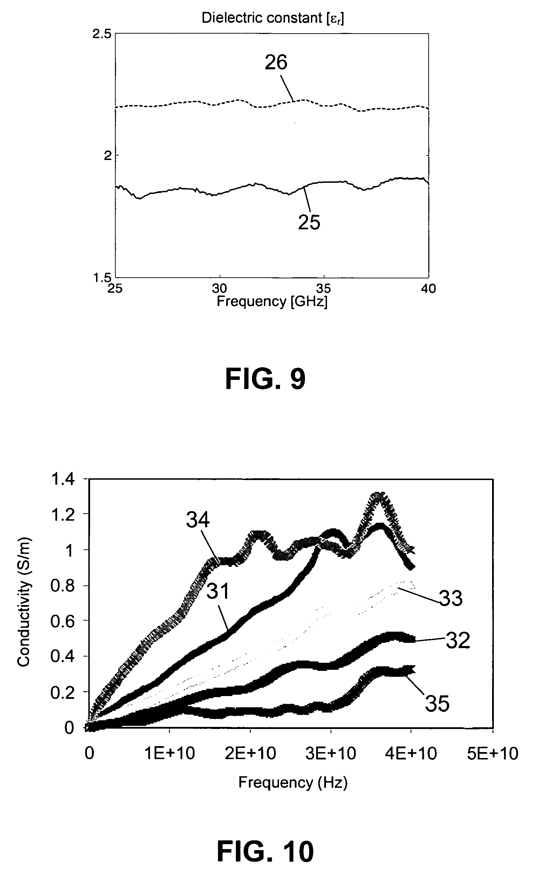

Lotader® (see curve 25 in Fig. 9) offers the advantage of presenting, in pure state or without CNTs, a dielectric constant lower than the dielectric constant of polycaprolactone one (see curve 26 in Fig. 9). Therefore, according to embodiments of the present invention, a layer of a non-foamed composite Lotader®+CNT may be sandwiched in between two layers of polycaprolactone (PCL) to form a tri-layer structure. This leads to an improved reflectivity of the resulting composite, comparable and even higher than the reflectivity of foamed tri-layers with polycaprolactone as a polymer (see above). This is illustrated in Fig. 8A and 8B which respectively show the shielding effectiveness and reflectivity for a monolayer of foamed PCL with 1wt% or 0.107 vol% CNT (curve 27), solid Lotader® with 2 wt% CNT (curve 28) and foamed PCL with 4 wt% or 0.541 vol% CNT (curve 29) and for a tri-layer comprising a first layer of PCL + 1 wt% or 0.107 vol% CNT, a second layer of solid Lotader® + 2 wt% CNT and third layer of PCL + 4 wt% or 0.541 vol% CNT (curve 30).
In conclusion, powerful tri-layers composite material structures containing carbon nanotubes for EMI shielding applications can be obtained using a polar polymer matrix, by using an extrusion or co-precipitation process.

Evaluation test 5

Moreover, it appears that the performances obtained and described above are not limited to the use of nanotubes (CNT) only: the combination of carbon nanotubes and carbon black (CB) particles as carbon based conductive loads allow obtaining a composite with improved properties compared to a composite only loaded with CNT or CB particles.

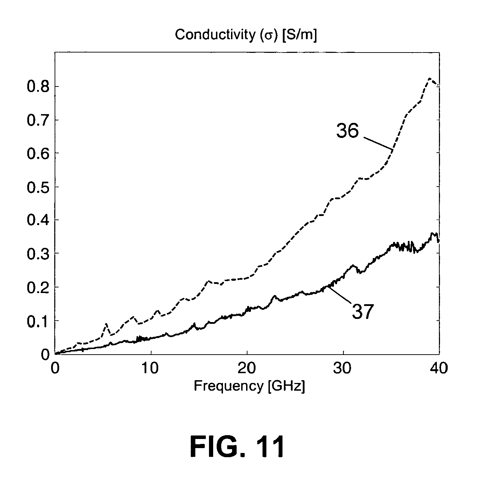

Fig. 10 shows that the conductivity of a foamed 0.7 wt% carbon nanotube/polycaprolactone composite (see curve 31) is higher than the conductivity of a foamed carbon black/polycaprolactone composite (see curve 32 (2 wt% CB) and curve 33 (5 wt% CB)). A concentration of 10 wt% CB (see curve 34) is required to reach a conductivity higher than or equal to the conductivity of a sample of PCL with 0.7 wt% of CNTs. For comparison reasons, curve 35 illustrates the conductivity for a pure PCL polymer (without CNTs or CB). Fig. 11 illustrates that the conductivity for a foamed Lotader® composite material comprising 2 wt% CNT and 2 wt% CB (see curve 36) is higher than for a foamed Lotader® composite material comprising only 2 wt% CNT (see curve 37). There is thus a particular synergy between the CNT and the CB particles which improves the conductivity compared to the composite materials comprising only one type of carbon based conductive load. It has to be noted that when a combination of CNTs and CB particles is used in a polymer composite material, preferably a concentration of at least 2 wt% may be used because when e.g. only 1 wt% of CB particles is used, there may no increase of conductivity be observed.
It is to be understood that although preferred embodiments, specific constructions and configurations, as well as materials, have been discussed herein for devices according to the present invention, various changes or modifications in form and detail may be made without departing from the scope and spirit of this invention. For example, any formulas given above are merely representative of procedures that may be used. Steps may be added or deleted to methods described within the scope of the present invention.

**Claims**

1. Polymer composite material structure comprising at least one layer of a foamed polymer composite material comprising:

- a foamed polymer matrix,
- an amount of between 0.1 and 6 wt% carbon based conductive loads dispersed in the foamed polymer matrix,

wherein the polymer composite material structure has a reflectivity between -5 and -20 dB.

2. Polymer composite material structure according to claim 1, wherein the foamed polymer matrix is an annealed foamed polymer matrix.

3. Polymer composite material structure according to claim 1 or 2, furthermore comprising at least one layer of a non-foamed polymer composite material.

4. Polymer composite material structure according to any of the previous claims, wherein the polymer composite material structure has a shielding effectiveness of between 5 and 90 dB.

5. Polymer composite material structure according to claim 4, wherein the polymer composite material structure has a shielding effectiveness of between 40 and 90 dB, preferably between 70 and 90 dB.

6. Polymer composite material structure according to any of the previous claims, wherein the amount of carbon based conductive loads is between 0.5 and 4 wt%, preferably between 0.5 and 2 wt%.

7. Polymer composite material structure according to any of the previous claims, wherein the polymer composite material structure has a reflectivity of between -10 and -20 dB, preferably between -15 and -20 dB.

8. Polymer composite material structure according to any of the previous claims, wherein the carbon based conductive loads comprise carbon nanotubes.

9. Polymer composite material structure according to any of claims 1 to 7,
wherein the carbon based conductive loads comprise carbon nanotubes and carbon black particles.

10. Polymer composite material structure according to claim 8 or 9, wherein the carbon nanotubes are multi-wall carbon nanotubes.

11. Polymer composite material structure according to any of claims 8 to 10,
wherein the carbon nanotubes are functionalised.

12. Polymer composite material structure according to any of the previous claims, wherein the polymer matrix comprises a polar polymer.

13. Polymer composite material structure according to claim 12, wherein the polar polymer is a polyester.

14. Use of the polymer composite material structure according to any of claims 1 to 13 as an electromagnetic interference shield in radio frequency systems.

15. Method for forming a polymer composite material structure, wherein the method comprises providing at least one layer of a foamed polymer composite material by:

- providing a polymer matrix,
- dispersing an amount of 0.1 to 6 wt% carbon based conductive loads hereby forming a polymer composite material,
- foaming the polymer composite material,
- and providing an annealed polymer composite material by annealing the polymer composite material before foaming or by annealing the foamed polymer composite material.

16. Method according to claim 15, further comprising providing at least one layer of a non-foamed polymer composite material by:

- providing a polymer matrix,
- dispersing an amount of 0.1 to 6 wt% carbon based conductive loads hereby forming a polymer composite material, and
- optionally annealing the polymer composite material.

17. Method according to claim 15 or 16, wherein annealing is performed at a temperature equal to or higher than the glass transition temperature (Tg) of the polymer matrix or equal to or higher than the melting point (Tm) of the polymer matrix.

18. Method according to any of claims 15 to 17, furthermore comprising pelletizing the polymer composite material before annealing.

19. Method according to any of claims 15 to 18, wherein foaming the composite material is performed by adding a chemical or physical foaming agent to the polymer composite material.

**FIG. 1**

**FIG. 2 – PRIOR ART**

**FIG. 3**

(a)           (b)

**FIG. 4**

## Shielding effectiveness [dB]

Frequency (GHz)

## Shielding effectiveness [dB]

Frequency (GHz)

## FIG. 5A

## Reflectivity [dB]

Frequency (GHz)

## Reflectivity [dB]

Frequency (GHz)

## FIG. 5B

**FIG. 6A**

**FIG. 6B**

**FIG. 6C**

Conductivity [S/m]

**FIG. 7**

Shielding effectiveness [dB]

**FIG. 8A**

Reflectivity [dB]

**FIG. 8B**

Dielectric constant [ε_r]

**FIG. 9**

**FIG. 10**

FIG. 11

**European Patent Office**

## EUROPEAN SEARCH REPORT

Application Number

EP 06 02 5002

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | DATABASE WPI Week 199724 Derwent Publications Ltd., London, GB; AN 1997-265583 XP002436716 & JP 09 092996 A (MATSUSHITA ELECTRIC WORKS LTD) 4 April 1997 (1997-04-04) | 1,4-7, 12,14 | INV. C08J9/00 H05K9/00 |
| Y | * abstract * | 3,8, 10-12 | |
| Y | PARK ET AL: "Fabrication and electromagnetic characteristics of electromagnetic wave absorbing sandwich structures" COMPOSITES SCIENCE AND TECHNOLOGY, ELSEVIER, vol. 66, no. 3-4, March 2006 (2006-03), pages 576-584, XP005197026 ISSN: 0266-3538 * page 578, paragraph 3.2 - page 579, paragraph 3.3 * | 3,8, 10-12 | |
| X | DATABASE WPI Week 200124 Derwent Publications Ltd., London, GB; AN 2001-228693 XP002436717 & JP 2000 294978 A (SEKISUI CHEM IND CO LTD) 20 October 2000 (2000-10-20) * abstract * | 1 | TECHNICAL FIELDS SEARCHED (IPC) C08J H05K |

The present search report has been drawn up for all claims

| Place of search | Date of completion of the search | Examiner |
|---|---|---|
| The Hague | 7 June 2007 | Oudot, René |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 02 5002

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2007

| Patent document cited in search report | Publication date | Patent family member(s) | Publication date |
|---|---|---|---|
| JP 9092996          A | 04-04-1997 | NONE | |
| JP 2000294978       A | 20-10-2000 | NONE | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0930323 A

**Non-patent literature cited in the description**

- **NEO.** *IEEE Transactions on Electromagnetic Compatibility,* February 2004, vol. 46 (1), 102-106
- **YANG.** *Adv. Mat,* 2005, (17), 1999-2003
- **YANG et al.** *Nano Letters,* 2005, vol. 5 (11), 2131-2134
- Rompp Lexikon Chemie. Georg-Thieme-Verlag, 1998, 465-466
- **A. SAIB et al.** *IEEE Trans. on Microwave theory and techniques,* June 2006, vol. 54 (6
- **YANG et al.** *Adv. Mat.,* 2005, (17), 1999-2003
- **YANG.** *Nano Letters,* 2005, vol. 5 (11), 2131-2134